# EUROPEAN PATENT APPLICATION

(11) **EP 4 697 041 A1**
(43) Date of publication of application: **18.02.2026**
(21) Application number: 23933112.7
(22) Date of filing: 13.12.2023
(51) Int. Cl.: G01R 31/392, G01R 31/396, H01M 10/42, H01M 10/48, H02J 7/00

(54) **CONTROL DEVICE, BATTERY PERFORMANCE ESTIMATION METHOD, AND PROGRAM**

(30) Priority: 11.04.2023 JP 2023064452
(71) Applicant: AESC Japan Ltd., Yokohama-shi, Kanagawa 220-0012 (JP)
(72) Inventor: YOSHIDA, Tadahiro, Zama-shi, Kanagawa 252-0012 (JP); ISOBE, Takayuki, Zama-shi, Kanagawa 252-0012 (JP); KOMATSU, Kohei, Zama-shi, Kanagawa 252-0012 (JP)
(74) Representative: Mathys & Squire
(86) International application number: PCT/JP2023/044677
(87) International publication number: WO 2024/214338

(57) **Abstract**

A control device (10) includes a module information management unit (110) and a performance information output unit (120). The module information management unit (110) estimates the degradation state of each of the plurality of battery modules to generate module information indicating the degradation state of each of the battery modules, and stores the module information in a non-volatile memory (30). The performance information output unit (120) outputs performance information indicating the performance of the battery pack based on the module information stored in the non-volatile memory (30). **In** response to the replacement of at least one of the plurality of battery modules included in the battery pack (20), the module information management unit (110) updates the information corresponding to the at least one battery module in the module information, and the performance information output unit (120) updates the performance information based on the information corresponding to the battery module other than the at least one battery module.

## Description

### TECHNICAL FIELD

The present invention relates to a technique of estimating a performance of a battery.

### BACKGROUND ART

A chargeable battery is used in various applications. A performance of a chargeable and dischargeable battery can be estimated based on a state of the battery.

An example of a technique of estimating a performance of a chargeable and dischargeable battery is disclosed in Patent Document 1. Patent Document 1 discloses a technique of calculating a module state for each of a plurality of battery modules and determining a performance of a battery pack configured to include the plurality of battery modules based on a minimum value among the calculated plurality of module states.

### RELATED DOCUMENT

### PATENT DOCUMENT

Patent Document 1: Japanese Unexamined Patent Publication No. 2017-004955

### SUMMARY OF THE INVENTION

### TECHNICAL PROBLEM

A battery pack in which a plurality of chargeable and dischargeable batteries are combined is used as a power source of a product driven by electric power. The demand for such battery packs has increased over the years, and as a result, a cost of battery packs has increased. The performance of the battery pack is degraded by various factors such as the number of uses and an elapse of time, and the battery pack eventually reaches an end of life, so that the battery pack needs to be replaced. A technique of reducing a cost of replacing the battery pack is desired.

An example of an object of the present invention is to provide a technique of reducing a cost of dealing with a case in which the performance of the battery pack is degraded.

### SOLUTION TO PROBLEM

In one embodiment, there is provided a control device including:
a module information management unit that estimates a degradation state of each of a plurality of battery modules to generate module information indicating the degradation state of each battery module and stores the module information in a non-volatile memory, and
a performance information output unit that outputs performance information indicating a performance of a battery pack configured to include the plurality of battery modules, based on the module information stored in the non-volatile memory, in which
the module information management unit updates, in response to replacement of at least one of the plurality of battery modules, information corresponding to the at least one battery module in the module information, and
the performance information output unit updates, in response to replacement of at least one of the plurality of battery modules, the performance information based on information corresponding to a battery module other than the at least one battery module.

**In** one embodiment, there is provided a battery performance estimation method including:
by at least one computer,
estimating a degradation state of each of a plurality of battery modules to generate module information indicating the degradation state of each battery module, and storing the module information in a non-volatile memory,
outputting performance information indicating a performance of a battery pack configured to include the plurality of battery modules, based on the module information stored in the non-volatile memory,
updating, in response to replacement of at least one of the plurality of battery modules, information corresponding to the at least one battery module in the module information, and
updating, in response to replacement of at least one of the plurality of battery modules, the performance information based on information corresponding to a battery module other than the at least one battery module.

**In** one embodiment, there is provided a program causing at least one computer to function as:
a unit that estimates a degradation state of each of a plurality of battery modules to generate module information indicating the degradation state of each battery module, and stores the module information in a non-volatile memory,
a unit that outputs performance information indicating a performance of a battery pack configured to include the plurality of battery modules, based on the module information stored in the non-volatile memory,
a unit that, in response to replacement of at least one of the plurality of battery modules, updates information corresponding to the at least one battery module in the module information, and
a unit that, in response to replacement of at least one of the plurality of battery modules, updates the performance information based on information corresponding to a battery module other than the at least one battery module.

### ADVANTAGEOUS EFFECTS OF INVENTION

According to the present invention, it is possible to reduce a cost of dealing with a case in which the performance of the battery pack is degraded.

### BRIEF DESCRIPTION OF THE DRAWINGS

FIG. 1 is a diagram illustrating a usage environment of a control device according to the present disclosure.
FIG. 2 is a diagram illustrating a functional configuration of a control device according to a first embodiment.
FIG. 3 is a diagram illustrating a hardware configuration of an integrated circuit.
FIG. 4 is a flowchart for illustrating an operation of the control device according to the first embodiment.
FIG. 5 is a flowchart for illustrating the operation of the control device according to the first embodiment.
FIG. 6 is a diagram for describing a specific flow of processing of S112 and S114.
FIG. 7 is a diagram for describing a specific flow of the processing of S112 and S114.
FIG. 8 is a flowchart for illustrating an operation of a control device according to a second embodiment.
FIG. 9 is a diagram illustrating a specific example of a result of estimating a degradation state for each of a plurality of cells included in a battery module that is a processing target.

### DESCRIPTION OF EMBODIMENTS

Hereinafter, an embodiment of the present invention will be described with reference to the drawings. In all drawings, the same constitutional elements are designated by the same reference numerals, and the description thereof will not be repeated. Further, in each block diagram, each block represents a functional unit configuration, not a hardware unit configuration, unless otherwise specified. In addition, a direction of an arrow in the drawing is only for easy understanding of the flow of information or the like, and does not limit a communication direction (one-way communication or two-way communication) unless otherwise specified.

### · Outline

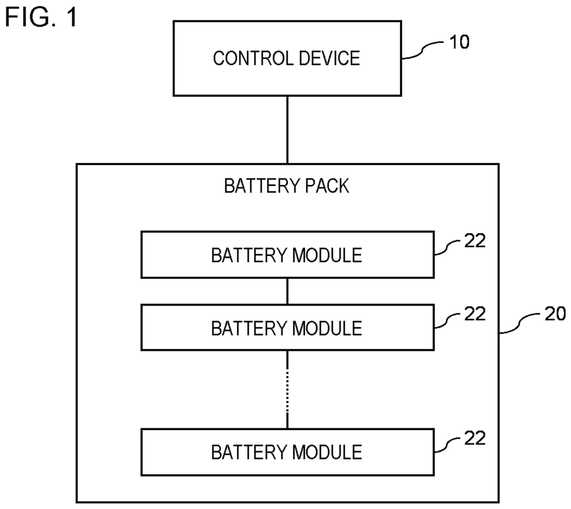

FIG. 1 is a diagram illustrating a usage environment of a control device 10 according to the present disclosure. In the usage environment illustrated in FIG. 1, the control device 10 is connected to a battery pack 20.

The battery pack 20 is attached to an electrically driven product (not illustrated) and functions as a power source of the electrically driven product. The battery pack 20 includes two or more battery modules 22. The battery module 22 is a configuration unit in which a plurality of cells are combined and packaged. The cell is a minimum configuration unit that independently has a function of a battery. In addition, although not illustrated, the battery pack 20 may include other components such as a charge and discharge circuit, a protection circuit, and a cooling mechanism.

The control device 10 includes at least a function of managing a degradation state of each of the plurality of battery modules 22 included in the battery pack 20 and a function of estimating a performance of the battery pack 20 based on the degradation state of each battery module 22. The former function is a function of estimating the degradation state of each of the plurality of battery modules 22 included in the battery pack 20 to generate information indicating the degradation state of each battery module (hereinafter, also referred to as "module information"), and storing the generated module information in a predetermined storage region. In addition, the latter function is a function of outputting information indicating the performance of the battery pack 20 (hereinafter, also referred to as "performance information") based on the module information stored in the predetermined storage region.

The control device 10 may have a function as a battery management system (BMS). Alternatively, the control device 10 may be a device that extends a function of the BMS by being attached to the BMS. In addition, the control device 10 may be incorporated into the battery pack 20 as a component of the battery pack 20.

Hereinafter, in some embodiments, the control device 10 according to the present disclosure will be described.

### · First embodiment

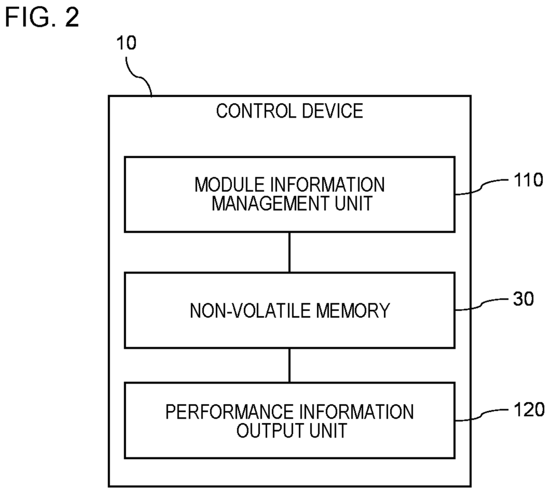

FIG. 2 is a diagram illustrating a functional configuration of the control device 10 according to a first embodiment. The control device 10 illustrated in FIG. 2 includes a module information management unit 110 and a performance information output unit 120 together with the non-volatile memory 30.

The module information management unit 110 estimates a degradation state of each of the plurality of battery modules 22 included in the battery pack 20. In addition, the module information management unit 110 generates module information indicating the degradation state of each of the battery modules 22 based on the estimation result of the degradation state of each of the plurality of battery modules 22. In addition, the module information management unit 110 stores the generated module information in a predetermined storage region, for example, the non-volatile memory 30 in the drawing. The non-volatile memory 30 may be provided outside the control device 10. For example, the non-volatile memory 30 may be provided inside the battery pack 20 or may be provided inside a battery management system (BMS) (not illustrated) that manages the battery pack 20.

The performance information output unit 120 outputs performance information indicating the performance of the battery pack 20 based on the module information stored in the non-volatile memory 30. The performance information output from the performance information output unit 120 is not particularly limited, but is, for example, information indicating a degradation state of the entire battery pack 20 or amount of available electric power from the entire battery pack 20.

**In** the control device 10 according to the present disclosure, in a case in which at least one of the plurality of battery modules 22 included in the battery pack 20 is replaced, the module information management unit 110 and the performance information output unit 120 each execute operations described below.

The module information management unit 110 updates the module information in response to the replacement of the at least one of the plurality of battery modules 22 included in the battery pack 20. Specifically, the module information management unit 110 updates information corresponding to the at least one battery module 22 in the module information.

The performance information output unit 120 updates the performance information of the battery pack 20 using the module information updated in response to the replacement of at least one of the plurality of battery modules 22 included in the battery pack 20. Specifically, the performance information output unit 120 updates the performance information of the battery pack 20 based on the information corresponding to the battery module 22 other than the at least one battery module 22.

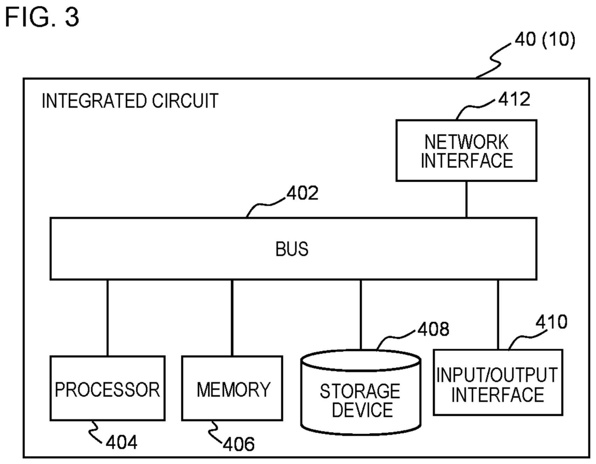

FIG. 3 is a diagram illustrating a hardware configuration of the integrated circuit 40. In the present drawing, the module information management unit 110 and the performance information output unit 120 of the control device 10 are implemented using the integrated circuit 40.

The integrated circuit 40 is, for example, a system on chip (SoC). The integrated circuit 40 includes a bus 402, a processor 404, a memory 406, a storage device 408, an input/output interface 410, and a network interface 412.

The bus 402 is a data transmission path for the processor 404, the memory 406, the storage device 408, the input/output interface 410, and the network interface 412 to transmit and receive data to and from each other. A method of connecting the processor 404 and the like to each other is not limited to the bus connection.

The processor 404 is an arithmetic processing unit realized using a microprocessor or the like.

The memory 406 is a main storage device implemented using a random access memory (RAM) or the like.

The storage device 408 is an auxiliary storage device realized using a Read Only Memory (ROM), a flash memory, or the like. The storage device 408 can function as the non-volatile memory 30 illustrated in FIG. 2.

The input/output interface 410 is an interface for connecting an input/output device to the integrated circuit 40 (control device 10). For example, an input device such as a keyboard or a touch panel, and an output device such as a display or a speaker are connected to the integrated circuit 40 (control device 10) via the input/output interface 410.

The network interface 412 is an interface for connecting the integrated circuit 40 (control device 10) to a communication network. The communication network includes, for example, a local area network (LAN), a wide area network (WAN), and a controller area network (CAN). A method of connecting the network interface 412 to the communication network may be a wireless connection or a wired connection.

The storage device 408 stores a program module corresponding to various functions of the control device 10. The storage device 408 stores at least a program module corresponding to the function of the module information management unit 110 described in the present disclosure and a program module corresponding to the function of the performance information output unit 120. The processor 404 implements a function corresponding to the program module by loading and executing the program module read from the storage device 408 on the memory 406. For example, the processor 404 implements the function of the module information management unit 110 described in the present disclosure by loading and executing the program module corresponding to the module information management unit 110 on the memory 406. **In** addition, for example, the processor 404 implements the function of the performance information output unit 120 described in the present disclosure by loading and executing the program module corresponding to the performance information output unit 120 on the memory 406. The operation of the processor 404 is common in the embodiments included in the present disclosure.

The hardware configuration of the integrated circuit 40 (control device 10) is not limited to the configuration shown in the drawing. For example, the program module corresponding to each function of the control device 10 may be stored in the memory 406. **In** this case, the integrated circuit 40 (control device 10) may not include the storage device 408.

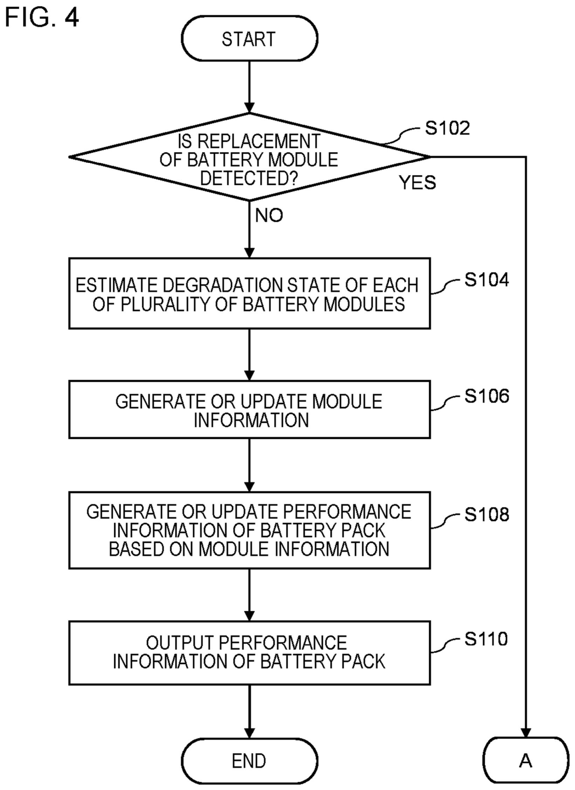

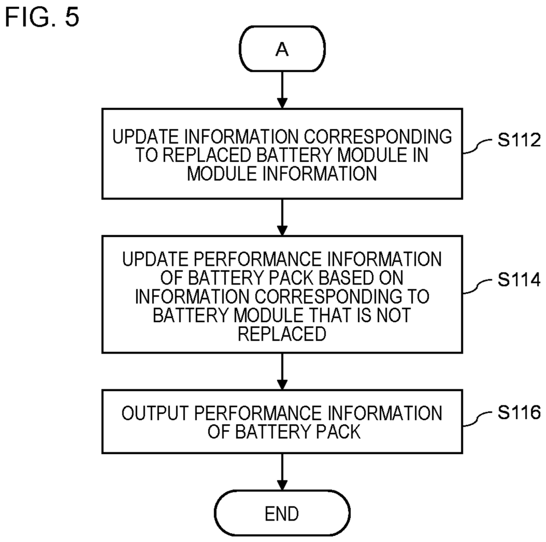

Hereinafter, an operation example of the control device 10 according to the first embodiment will be described with reference to the drawings. FIGS. 4 and 5 are flowcharts for illustrating an operation of the control device 10 according to the first embodiment.

The control device 10 monitors whether or not at least one of the plurality of battery modules 22 included in the battery pack 20 is replaced (S102). As an example, the control device 10 can determine whether or not the battery module 22 is replaced based on the metadata that can be acquired for each battery module 22, for example, data including individual identification information of each battery module 22. Specifically, in a case in which a new individual identification number is detected instead of at least one of the individual identification numbers managed in the module information stored in the non-volatile memory 30, the control device 10 can detect that at least one of the plurality of battery modules 22 is replaced.

In a case in which the replacement of the battery module 22 is not detected (S102: NO), the processing of S104 to S110 described below is executed. The processing S104 to S110 is executed at any timing. For example, the processing of S104 to S110 may be executed at a timing indicated by a schedule information stored in the memory 406 or the like in advance, or may be executed at a timing at which the power supply to the battery pack 20 ends.

First, the module information management unit 110 estimates the degradation state for each of the plurality of battery modules 22 (S104). The degradation state of the battery module 22 is not particularly limited, but is represented by, for example, an index value such as a state of health (SOH) or a state of resistance (SOR). **In** this case, the module information management unit 110 can use various known methods as a method of estimating the degradation state of the battery module 22.

Then, the module information management unit 110 generates or updates the module information stored in the non-volatile memory 30 based on the degradation state of each of the plurality of battery modules 22 estimated in the processing of S104 (S106). Specifically, in a case in which the module information is not stored in the non-volatile memory 30, the module information management unit 110 newly generates the module information based on the degradation state of each of the plurality of battery modules 22 estimated in the processing of S104, and stores the generated module information in the non-volatile memory 30. On the other hand, in a case in which the module information is already stored in the non-volatile memory 30, the module information management unit 110 updates the module information stored in the non-volatile memory 30 based on the degradation state of each of the plurality of battery modules 22 estimated in the processing of S104.

The performance information output unit 120 generates or updates the performance information of the battery pack 20 based on the module information generated or updated in the processing of S106 (S108). Specifically, in a case in which the module information is newly generated in the processing of S106, the performance information output unit 120 newly generates the performance information of the battery pack 20 based on the module information. The generated performance information is stored in a predetermined storage region, for example, the non-volatile memory 30. On the other hand, in a case in which the module information is updated in the processing of S106, the performance information output unit 120 updates the performance information of the battery pack 20 already stored based on the updated module information.

Here, the performance of the battery pack 20 depends on the battery module 22 that is most degraded among the plurality of battery modules 22. Therefore, in a case in which the degradation state of the plurality of battery modules 22 is represented by the SOH, the performance information output unit 120 preferably identifies the lowest value from the SOH of the plurality of battery modules 22, and generates the identified lowest value of the SOH as the performance information of the battery pack 20. **In** addition, in a case in which the degradation state of the plurality of battery modules 22 is represented by the SOR, the performance information output unit 120 preferably identifies the maximum value from the SOR of the plurality of battery modules 22, and generates the identified maximum value of the SOR as the performance information of the battery pack 20. In this manner, information that appropriately indicates the performance of the battery pack 20 is obtained.

Then, the performance information output unit 120 outputs the performance information of the battery pack 20 (S110). As an example, the performance information output unit 120 displays the performance information generated or updated in the processing of S108 on a display (not shown) connected to the control device 10 via the input/output interface 410. As another example, the performance information output unit 120 may output the performance information generated or updated in the processing of S108 to another processing unit (not shown) that executes processing using the performance information of the battery pack 20. The other processing unit may be a processing unit provided in another device different from the control device 10.

Returning to the description of the determination processing of S102, in a case in which the replacement of the battery module 22 is detected (S102: YES), the processing of S112 to S116 illustrated in FIG. 5 is executed.

First, the module information management unit 110 updates the information corresponding to the replaced battery module in the module information (S112). As an example, the module information management unit 110 operates as follows. The module information management unit 110 identifies the information corresponding to the battery module 22 that is no longer detected as the information to be updated. Specifically, the module information management unit 110 identifies the undetected individual identification number from among the plurality of individual identification numbers managed in the module information. Then, the module information management unit 110 identifies the information associated with the individual identification number as the information to be updated. Then, the module information management unit 110 replaces the information to be updated with the information of the newly detected battery module 22. As a result, the module information stored in the non-volatile memory 30 is updated to the state after the replacement of the battery module 22. A specific flow of the processing of updating the module information in response to the replacement of the battery module 22 will be described with reference to another drawing.

Then, the performance information output unit 120 updates the performance information of the battery pack 20 based on the information corresponding to the battery module 22 that is not replaced (S114). For example, the performance information output unit 120 identifies the information corresponding to the battery module 22 that is not identified as a target in the processing of S112 as the information corresponding to the battery module 22 that is not replaced. Then, the performance information output unit 120 updates the performance information of the battery pack 20 based on the information identified in this way. A specific flow of the processing of updating the performance of the battery pack 20 in response to the replacement of the battery module 22 will be described with reference to another drawing.

Then, the performance information output unit 120 outputs the performance information of the battery pack 20 updated in the processing of S114 (S116). This processing is the same as the processing of S110 in FIG. 4.

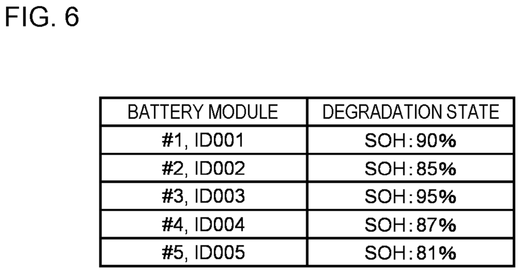

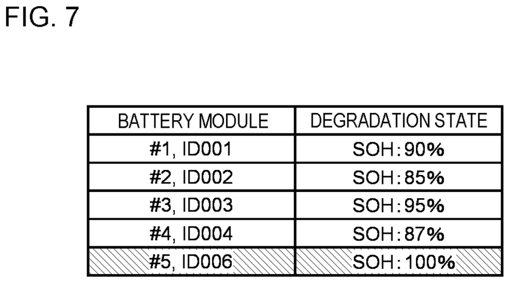

FIGS. 6 and 7 are diagrams for describing a specific flow of the processing of S112 and S114. FIG. 6 illustrates the module information before at least one of the plurality of battery modules 22 is replaced. FIG. 7 illustrates the module information after at least one of the plurality of battery modules 22 is replaced. In the examples of FIGS. 6 and 7, the battery pack 20 includes five battery modules 22 having different individual identification numbers.

First, a flow of the processing of updating the module information by the module information management unit 110 will be described. As an example, it is assumed that the battery module 22 having an individual identification number of "ID005" is replaced with the battery module 22 having an individual identification number of "ID006" as illustrated in FIG. 7. In this case, since the battery module 22 having the individual identification number of "ID005" is not detected in the module information illustrated in FIG. 6, the module information management unit 110 identifies information related to the individual identification number "ID005", specifically, information of the bottom row of the module information illustrated in FIG. 6, as the information to be updated. Then, the module information management unit 110 updates the information identified as the information to be updated as illustrated in FIG. 7.

Here, the module information management unit 110 sets the degradation state of the replaced battery module 22, that is, the battery module 22 having the individual identification number of "ID006", to a predetermined value. It is not particularly limited, but in the example of FIG. 7, the module information management unit 110 sets "SOH: 100%" as the degradation state of the replaced battery module 22. Since the battery module 22 to be replaced is considered to be usually new or in a like-new condition, the module information management unit 110 may set a new or new-like value (for example, a value of 98% or more) as the information of the replaced battery module 22. In addition, since the battery module 22 to be replaced is considered to be usually new or in a like-new condition, it can be said that the performance of the battery pack 20 is not significantly affected by the battery module 22 immediately after the replacement. Therefore, an accuracy of information set for the replaced battery module 22 does not need to be so high. Even in a case in which the accuracy of the information set immediately after the replacement is low, the accuracy of the information related to each battery module 22 is maintained by the processing of updating the module information (for example, the processing of S104 of FIG. 4) executed thereafter.

Next, a flow of the processing of updating the performance information of the battery pack 20 by the performance information output unit 120 will be described. First, in a case in which the information illustrated in FIG. 6 as the module information is stored in the non-volatile memory 30, the performance information output unit 120 can output, for example, the lowest value (SOH: 81%) of the degradation state as the performance information of the battery pack 20. Thereafter, in a case in which the module information is updated as illustrated in FIG. 7 due to the replacement of a certain battery module 22, the performance information output unit 120 updates the performance information of the battery pack 20 by using the information corresponding to the battery module 22 that is not replaced. Specifically, the performance information output unit 120 identifies the information related to the battery module 22 having an individual identification number other than "ID005" as the information used to update the performance information of the battery pack 20. In the example of FIG. 7, the performance information output unit 120 identifies the information related to the four battery modules 22 having the individual identification numbers "ID001" to "ID004" as the information to be processed. Here, among the four identified battery modules 22, the degradation state of the battery module 22 corresponding to the individual identification number "ID002" shows the lowest value (SOH: 85%). In this case, the performance information output unit 120 updates the performance information of the battery pack 20 from the state before the replacement (SOH: 81%) to the state after the replacement (SOH: 85%).

An action and an effect of the control device 10 according to the first embodiment will be described. According to the present embodiment, in a case in which at least one of the plurality of battery modules 22 included in the battery pack 20 is replaced, the information corresponding to the replaced battery module 22 is updated, and the performance information indicating the performance of the battery pack 20 is updated by using the information corresponding to the battery module 22 other than the replaced battery module 22. By adopting such a configuration, it is possible to perform an operation of replacing only the battery module 22 that is the cause of the degradation in the performance of the battery pack 20 in a case in which the performance of the battery pack 20 is degraded. By making it possible to perform the replacement in units of the battery module 22, the cost can be reduced as compared to a case of replacing the entire battery pack 20.

In addition, in the present embodiment, the information used to generate the performance information of the battery pack 20 is stored in units of the battery module 22 included in the battery pack 20. As a result, the capacity of the data indicating the performance of the battery pack 20 can be reduced. By reducing the capacity of the data indicating the performance of the battery pack 20, for example, in a case in which such data is managed in a ROM or the like in the battery pack 20, a ROM having a low capacity can be used. That is, in such a case, an effect of reducing the manufacturing cost of the battery pack 20 can also be expected.

### · Second embodiment

The control device 10 according to the second embodiment has the same configuration as the first embodiment described above, except for the following points to be described below.

The control device 10 of the present embodiment has a functional configuration as shown in FIG. 2. However, the module information management unit 110 of the present embodiment operates as follows in a case of estimating the degradation state of each battery module 22. First, the module information management unit 110 estimates the degradation state of each of the plurality of cells constituting each battery module 22. Then, the module information management unit 110 identifies a predetermined number of cells in the order of the degradation progress based on the estimated degradation state of each of the plurality of cells. Then, the module information management unit 110 includes information indicating the degradation state of the identified predetermined number of cells in the module information as information indicating the degradation state of the corresponding battery module 22.

Here, the "predetermined number" can be set to any numerical value as a numerical value smaller than the total number of cells included in each battery module 22. As the "predetermined number" is smaller, the amount of information of the module information is smaller. As an example, the "predetermined number" is set to "a numerical value of 20% or less of the number of cells in series in each battery module 22". As another example, the "predetermined number" is set to "1". In this case, the effect of reducing the amount of information of the module information is larger in the latter case than in the former case.

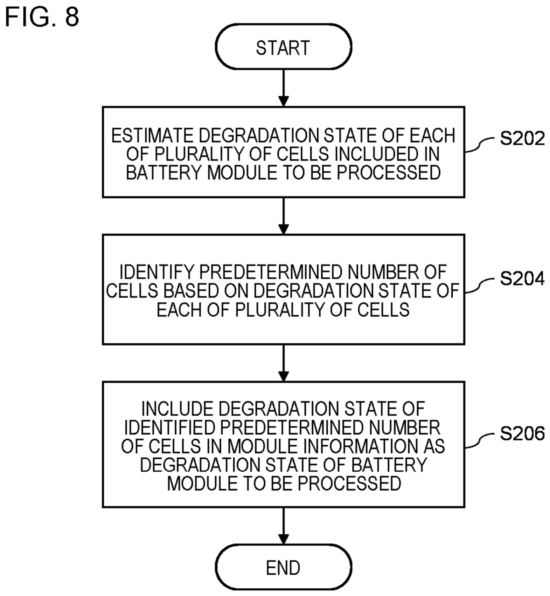

Hereinafter, an operation example of the control device 10 according to the second embodiment will be described with reference to the drawings. FIG. 8 is a flowchart for illustrating an operation of the control device 10 according to the second embodiment. In the flowchart of FIG. 8, a specific example of processing of estimating the degradation state of each battery module 22 is illustrated. The processing illustrated in the drawing is executed for each battery module 22 to be processed, for example, in S104 of FIG. 4 and S112 of FIG. 5 according to the first embodiment.

First, the module information management unit 110 estimates the degradation state of each of the plurality of cells included in the battery module 22 to be processed (S202). The module information management unit 110 can estimate the degradation state of each of the plurality of cells by a known method. For example, the module information management unit 110 can estimate the SOH or the SOR of each of the plurality of cells by using the voltage value, the current value, the temperature (the internal temperature or the ambient temperature) in the usage environment of the battery pack 20, and the like of each of the plurality of cells as input information.

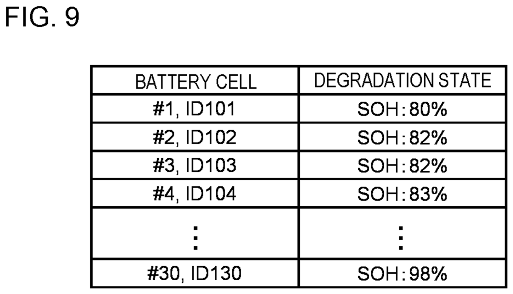

Next, the module information management unit 110 identifies a predetermined number of cells based on the estimated degradation state of each of the plurality of cells included in the battery module 22 to be processed (S204). For example, it is assumed that the battery module 22 to be processed includes 30 cells, and a result as illustrated in FIG. 9 is obtained as a result of the processing of S202. In the example of FIG. 9, a state in which information on the degradation state of the plurality of cells is arranged in ascending order of the degree of degradation is illustrated. The module information management unit 110 identifies a predetermined number of cells based on the result as illustrated in FIG. 9. For example, in a case in which the "predetermined number" is "10% of the total number of battery modules 22 included in the battery module 22", the module information management unit 110 identifies three cells from the top as the "predetermined number of cells". In addition, for example, in a case in which the "predetermined number" is "1", the module information management unit 110 identifies the top cell as the "predetermined number of cells". Information on the "predetermined number" is stored in advance in a storage region accessible by the module information management unit 110, such as the memory 406 and the storage device 408. The module information management unit 110 can recognize the "predetermined number" by referring to the information stored in the storage region.

Then, the module information management unit 110 includes the degradation state of the "predetermined number of cells" identified in S204 in the module information as information indicating the degradation state of the battery module 22 to be processed (S206). For example, in a case in which one cell is identified as the "predetermined number of cells", the module information management unit 110 includes the degradation state of the one cell in the module information as the degradation state of the battery module 22 to be processed. In a case in which one cell is identified as the "predetermined number of cells" in the state illustrated in FIG. 9, the module information management unit 110 includes the degradation state (SOH: 80%) of the top cell in the module information as information indicating the degradation state of the battery module 22 to be processed. In addition, in a case in which two or more cells are identified as the "predetermined number of cells", the module information management unit 110 includes the degradation states of the two or more cells in the module information as the degradation state of the battery module 22 to be processed. In a case in which three cells are identified as the "predetermined number of cells" in the state illustrated in FIG. 9, the module information management unit 110 includes the degradation states (SOH: 80%, SOH: 82%, and SOH: 82%, respectively) of the top three cells in the module information as the degradation state of the battery module 22 to be processed.

The control device 10 according to the second embodiment also provides the same functions and effects as those in the first embodiment.

Hereinabove, the embodiments of the present invention have been described with reference to the drawings. However, the embodiment is merely an example of the present invention, and various configurations other than the above-described configurations can also be adopted.

In addition, in the plurality of flowcharts used in the above description, a plurality of steps (processes) are described in order. However, the execution order of the steps to be executed in each of the embodiments is not limited to the order of that description. In each of the embodiments, the order of the steps shown in the diagram can be changed within a range that does not affect the content. In addition, the above embodiments can be combined within a range where their contents do not contradict each other.

This application claims priority based on Japanese Patent Application No. 2023-064452 filed on April 11, 2023, the entire disclosure of which is incorporated herein.

### REFERENCE SIGNS LIST

- 10:: control device
- 110:: module information management unit
- 120:: performance information output unit
- 20:: battery pack
- 22:: battery module
- 30:: non-volatile memory
- 40:: integrated circuit
- 402:: bus
- 404:: processor
- 406:: memory
- 408:: storage device
- 410:: input/output interface
- 412:: network interface

## Claims

1. A control device comprising:
a module information management unit that estimates a degradation state of each of a plurality of battery modules to generate module information indicating the degradation state of each battery module and stores the module information in a non-volatile memory; and
a performance information output unit that outputs performance information indicating a performance of a battery pack configured to include the plurality of battery modules, based on the module information stored in the non-volatile memory,
wherein the module information management unit updates, in response to replacement of at least one of the plurality of battery modules, information corresponding to the at least one battery module in the module information, and
the performance information output unit updates, in response to replacement of at least one of the plurality of battery modules, the performance information based on information corresponding to a battery module other than the at least one battery module.

2. The control device according to claim 1, wherein
the degradation state of the battery module is represented by a state of health (SOH) or a state of resistance (SOR).

3. The control device according to claim 1 or 2, wherein
the module information management unit estimates, for each battery module, a degradation state of each of a plurality of cells constituting the battery module,
identifies a predetermined number of cells in order of degradation based on the estimated degradation state of each of the plurality of cells, and
includes information indicating the degradation state of the identified predetermined number of cells in the module information as information indicating the degradation state of the battery module.

4. The control device according to claim 3, wherein
the predetermined number is 20% or less of the number of the plurality of cells in series in the battery module.

5. The control device according to claim 3, wherein
the predetermined number is 1.

6. The control device according to claim 1 or 2, wherein
the module information management unit sets the degradation state of the at least one battery module to a predetermined value in the update of the information corresponding to the at least one battery module.

7. A battery performance estimation method comprising:
by at least one computer,
estimating a degradation state of each of a plurality of battery modules to generate module information indicating the degradation state of each battery module, and storing the module information in a non-volatile memory;
outputting performance information indicating a performance of a battery pack configured to include the plurality of battery modules, based on the module information stored in the non-volatile memory;
updating, in response to replacement of at least one of the plurality of battery modules, information corresponding to the at least one battery module in the module information; and
updating, in response to replacement of at least one of the plurality of battery modules, the performance information based on information corresponding to a battery module other than the at least one battery module.

8. A program causing at least one computer to function as:
a unit that estimates a degradation state of each of a plurality of battery modules to generate module information indicating the degradation state of each battery module, and stores the module information in a non-volatile memory;
a unit that outputs performance information indicating a performance of a battery pack configured to include the plurality of battery modules, based on the module information stored in the non-volatile memory;
a unit that, in response to replacement of at least one of the plurality of battery modules, updates information corresponding to the at least one battery module in the module information; and
a unit that, in response to replacement of at least one of the plurality of battery modules, updates the performance information based on information corresponding to a battery module other than the at least one battery module.
